# EUROPÄISCHE PATENTSCHRIFT

(11) **EP 0 469 103 B1**
(45) Veröffentlichungstag und Bekanntmachung des Hinweises auf die Patenterteilung: **09.11.1994**
(21) Anmeldenummer: 91902978.5
(22) Anmeldetag: 07.02.1991
(51) Int. Cl.: B07C 5/344

(54) **VERFAHREN UND VORRICHTUNG ZUR RÜCKNAHME GEBRAUCHTER BATTERIEN**
PROCESS AND DEVICE FOR RECUPERATING USED BATTERIES
PROCEDE ET DISPOSITIF POUR LE RECYCLAGE DE PILES USAGEES

(30) Priorität: 13.02.1990 CH 466/90
(43) Veröffentlichungstag der Anmeldung: 05.02.1992
(73) Patentinhaber: EGAPRO AG, CH-8037 Zürich 5 (CH)
(72) Erfinder: SCHÜRMANN, Kurt, M., CH-6010 Kriens (CH)
(74) Vertreter: EGLI-EUROPEAN PATENT ATTORNEYS
(86) Internationale Anmeldenummer: CH9100033
(87) Internationale Veröffentlichungsnummer: WO9112094

(56) Entgegenhaltungen:
- EP-A- 0 102 428
- EP-A- 0 156 505
- US-A- 3 480 140
- US-A- 4 204 161

## Beschreibung

Die Erfindung bezieht sich auf ein Verfahren zur Rücknahme gebrauchter Artikel gemäss dem Oberbegriff des Anspruchs 1 sowie eine Vorrichtung zur Durchführung des Verfahrens.

Es sind Verfahren zur Rücknahme verschiedener Arten von gebrauchten Artikeln wie Konservendosen, Flaschen etc. bekannt, bei denen zumindest eine rudimentäre Prüfung des Artikels, z. B. auf elektrische Leitfähigkeit des Materials, erfolgt. Mit diesen einfachen Methoden kann gewöhnlich nur eine sehr grobe Einteilung mit einiger Sicherheit getroffen werden, z. B. nach metallischem oder nichtmetallischem Charakter des Materials.

Um Batterien, die mit ihrer weiten Verbreitung und ihrem hohen Gehalt an giftigen Stoffen wie Säuren und Schwermetallen ein sehr beträchtliches Umweltgefährdungspotential aufweisen, vom gewöhnlichen Haushaltsmüll getrennt zu halten und im Sinne einer sicheren Entsorgung zu sammeln, sollte man über Geräte verfügen, welche gebrauchte Batterien Zurücknehmen und dem Verbraucher durch Ausgabe einer Geldmünze oder eines Pfandes o. dgl. einen Anreiz bieten, von ihnen Gebrauch zu machen. Dabei ist jedoch zur Unterbindung von Missbrauch und Betrug ein Verfahren erforderlich, das eine sichere Unterscheidung gebrauchter Batterien von anderen Objekten erlaubt.

Aus der EP-A-0 156 505, die die Merkmale des Oberbegriffs des Anspruchs 1 zeigt, ist ein Gerät zum Wiederaufladen gebrauchter Batterien bekannt, welches Batterien an speziellen Markierungen erkennt. Ein solches Unterscheidungsverfahren ist jedoch, abgesehen davon, dass es offensichtlich nur eigens markierte Batterien erkennt und damit ohne Ueberwindung schwieriger organisatorischer und Normungsprobleme nicht allgemein anwendbar ist, nicht betrugssicher, was bei der vorgesehenen Verwendung, bei der ein Kunde für eine Dienstleistung bezahlt, die er normalerweise nicht mutwillig behindern wird, keine Rolle spielt, aber bei einem Rücknahmegerät mit Pfandausgabe nicht annehmbar ist.

Hier will die Erfindung Abhilfe schaffen. Die Erfindung, wie sie in den Ansprüchen gekennzeichnet ist, schafft ein Verfahren zur Rücknahme gebrauchter Batterien sowie eine Vorrichtung zu dessen Durchführung, bei welchem Batterien mit nahezu hundertprozentiger Sicherheit und ausschliesslich aufgrund spezifischer physikalischer Eigenschaften von anderen Artikeln unterschieden werden. Sie erlaubt es, Geräte ähnlich wie die inzwischen sehr bewährten Rücknahmegeräte für Getränkedosen für das Einsammeln der für die Umwelt wesentlich gefährlicheren Batterien zur Verfügung zu stellen, die keinerlei Vorbereitung derselben im Sinne spezieller Kennzeichnung erfordern und sehr weitgehende Sicherheit gegen betrügerische Manipulationen bieten.

Im folgenden wird die Erfindung anhand von lediglich einen Ausführungsweg darstellenden Zeichnungen dargestellt. Es zeigen
- Fig. 1: eine perspektivische Darstellung eines Teils eines erfindungsgemässen Rücknahmegeräts, wobei das Gehäuse weggelassen ist,
- Fig. 2: einen um Gehäuseteile etc. ergänzten senkrechten Schnitt durch das Gerät gemäss Fig. 1,
- Fig. 3a: eine Vorderansicht des Geräts nach Fig. 1,
- Fig. 3b: im wesentlichen einen Draufblick auf das Gerät entsprechend Fig. 1, wobei ein kleiner Teil waagrecht geschnitten dargestellt ist,
- Fig. 4a: eine Vorderansicht des Aufnahmefachs des Geräts nach Fig. 1 in natürlicher Grösse, wobei Standardtypen von Batterien gestrichelt eingezeichnet sind,
- Fig. 4b: einen Schnitt längs der Linie B - B in Fig. 4a und
- Fig. 5: ein Flussdiagramm, das die Durchführung des erfindungsgemässen Verfahrens durch das Gerät nach den Fig. 1 bis 4b darstellt.

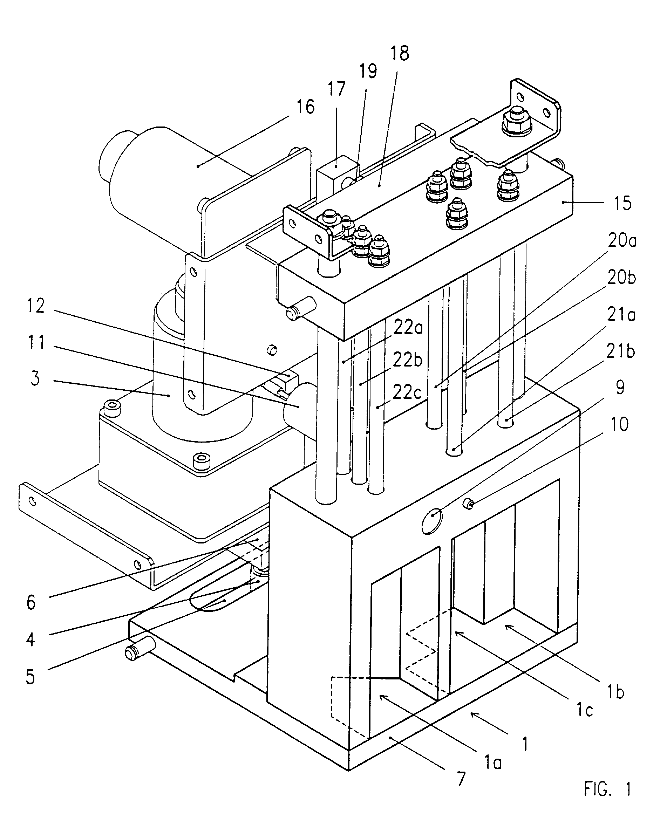

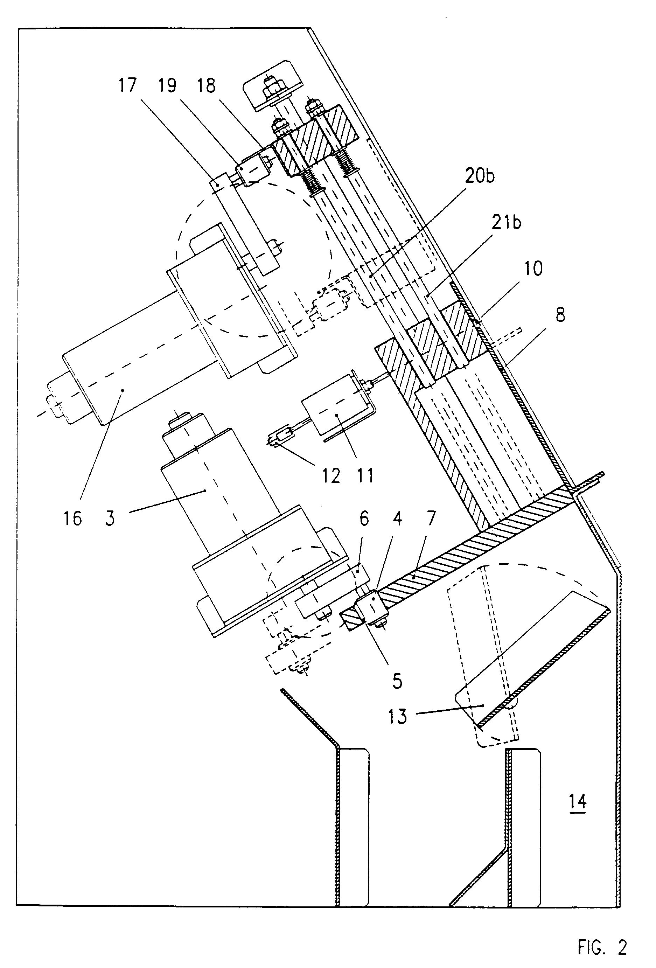

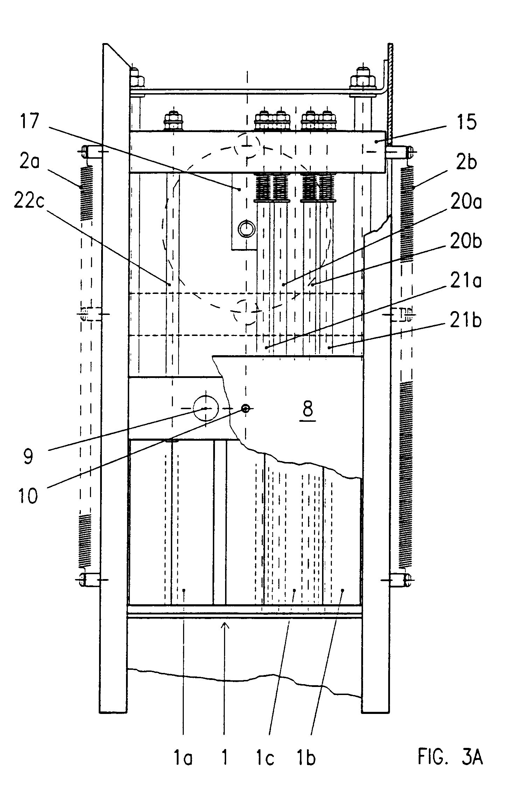

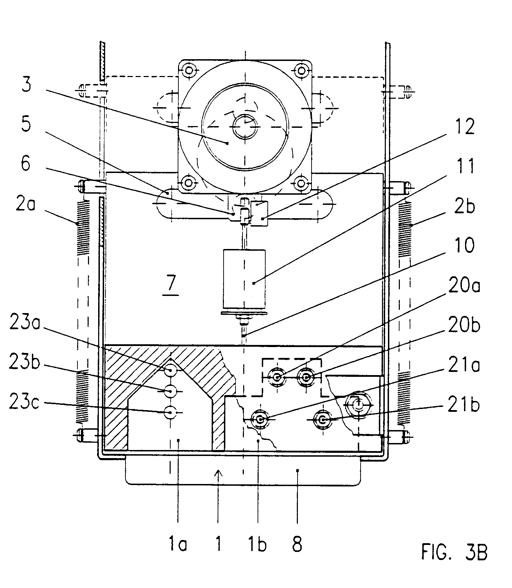

Das in den Fig. 1 bis 4b dargestellte Rücknahmegerät weist ein zweigeteiltes Aufnahmefach 1 auf mit einem linken Teilfach 1a und einem rechten Teilfach 1b, in dessen Rückwand eine Nische 1c eingelassen ist. Seine untere Begrenzung bildet eine von einem Elektromotor 3 durch einen in mit einer Rolle 4 in einen Schlitz 5 eingreifenden Hebel 6 verschiebbare Bodenplatte 7, die nach innen geneigt ist (Fig. 2). Vorne ist das Aufnahmefach 1 durch einen manuell betätigbaren Schieber 8 (in Fig. 1 ganz und in Fig. 3a teilweise weggelassen) verschliessbar. Ein Sensor 9 dient dazu, festzustellen, ob der Schieber 8 ganz geschlossen ist oder nicht. In der Verschlussstellung kann derselbe durch einen Riegel 10 gesperrt werden, der durch einen Elektromagneten 11 betätigt wird. Zur Ueberwachung der Position des Riegels 10 dient ein Mikroschalter 12. Unterhalb der Bodenplatte 7 ist eine Weiche 13 (Fig. 2) eingebaut, die durch einen Elektromotor betätigt wird und den Weg entweder in einen Rückgabeschacht 14 oder einen Sammelbehälter freigibt.

Eine Halterung 15 wird durch die Federn 2a,b mit einer nach unten wirkenden Kraft beaufschlagt, gegen die sie durch einen Elektromotor 16 über einen Hebel 17, der eine auf einen Flansch 18 einwirkende Rolle 19 trägt, nach oben bewegt werden kann. An der Halterung 15 sind zwei Paare von metallenen Stempeln 20a,b, 21a,b gefedert und drei Stempel 22a,b,c ungefedert befestigt. Die Stempel 20a,b und 21a,b bilden Kontaktstückpaare, während die Stempel 22a,b,c jeweils mit in die Bodenplatte 7 eingelassenen Kontakten 23a,b,c zusammenwirken. Die Kontaktstücke 20a, 21a sowie 22a,b,c sind zusammengeschaltet und an den einen Pol einer Spannungsmessschaltung und einer Generatorschaltung gelegt, die Kontaktstücke 20b, 21b und 23a,b,c sind mit den entgegengesetzten Polen beider Schaltungen verbunden. Dabei kommt es auf die Polung nicht an, da die Spannungsmessschaltung so ausgelegt ist, dass sie auf den Betrag der Spannung anspricht und sich ausserdem herausgestellt hat, dass die Generatorschaltung, die, wie weiter unten näher ausgeführt werden wird, dazu dient, ins Aufnahmefach eingelegte Batterien falls nötig geringfügig aufzuladen, ihre Aufgabe unabhängig von der Polung der Batterie erfüllen kann.

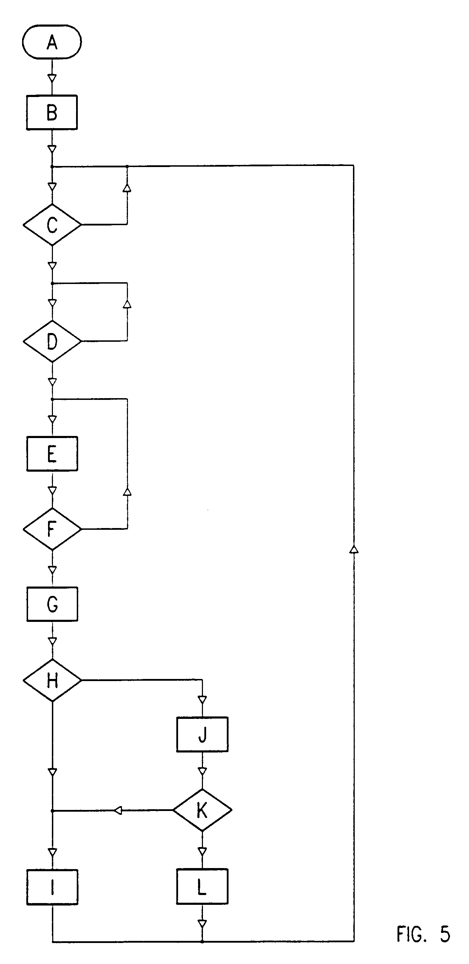

Im folgenden wird der Ablauf einer Batterierücknahme am Beispiel einer handelsüblichen 4,5 V - Batterie beschrieben, wobei auch auf Fig. 5 Bezug genommen wird. Wird das Gerät eingeschaltet (A in Fig. 5), so wird es automatisch initialisiert und überprüft selbsttätig seine Funktionsfähigkeit, die diversen Elektromotoren etc. nehmen ihre Grundstellungen ein (B). Der Sensor 9 überprüft periodisch, ob der Schieber 8 geschlossen ist (C). Wird nun eine 4,5 V - Batterie in aufrechter Position in das rechte Teilfach 1b eingelegt, so muss vorerst der Schieber 8 geöffnet werden. Der Sensor 9 stellt das fest und der Rücknahmeprozess geht einen Schritt weiter nach D, wo ebenfalls durch den Sensor 9 ständig überprüft wird, ob der Schieber 8 noch offen ist. Wird die 4,5 V - Batterie nun in aufrechter Position in das rechte Teilfach 1b eingelegt, so gleitet sie unter der Wirkung ihres Gewichts an die Rückwand, jedoch nicht in die Nische 1c, da sie breiter ist als diese. Wird der Schieber 8 losgelassen, so fällt er zurück in die Verschlussstellung. Die Ueberprüfung durch den Sensor 9 (Schieber 8 offen: ja oder nein?) ergibt nun ein negatives Resultat und es wird durch den Elektromagneten 11 der Riegel 10 zu schliessen versucht (E), bis der Mikroschalter 12 feststellt (F), dass das Schliessen des Riegels 10 ausgeführt ist.

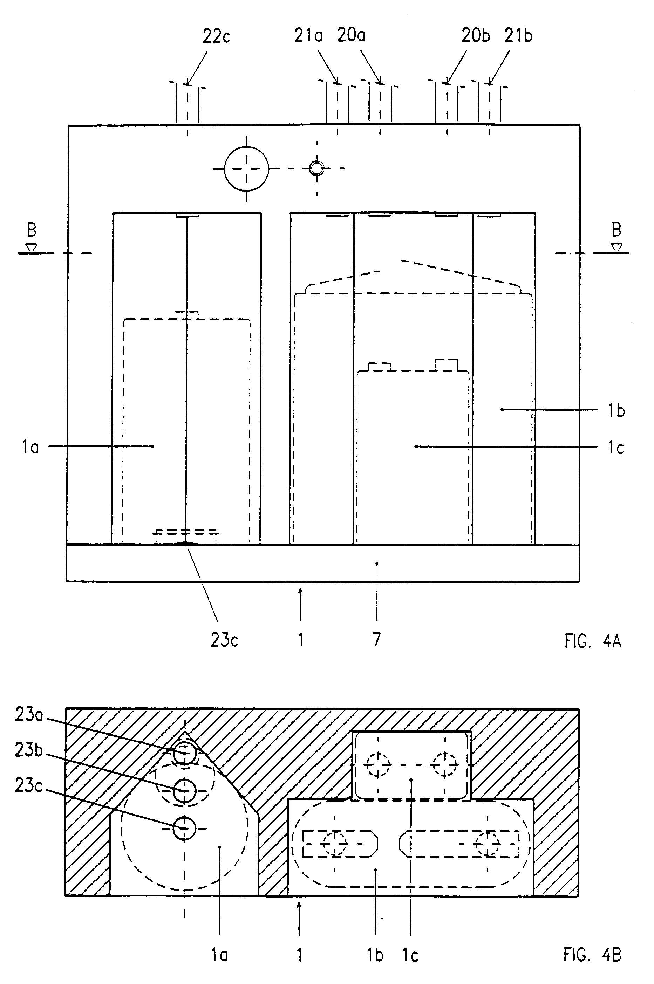

Aus Sicherheitsgründen wird erst dann (G) der Hebel 17 durch den Elektromotor 16 gesenkt, sodass die Halterung 15 durch die Federn 2a,b nach unten gezogen wird. Die Stempel 21a,b - in Fig. 4b rechts zeigen Kreuze die Stempelpositionen an, während sie links denen der eingezeichneten Kontakte 23a,b,c entsprechen - treffen auf die Kontaktlaschen der Batterie und verhindern weitere Bewegung der Halterung 15 nach unten, während die übrigen Stempel 20a,b, 22a,b,c ins Leere gehen. Durch die federnde Aufhängung der Stempel 21a,b an der Halterung 15 werden eventuelle Höhenunterschiede zwischen den Kontaktlaschen ausgeglichen. Die Stempel 21a,b sind übrigens, wie aus Fig. 4a ersichtlich, so angeordnet, dass auch bei stark verkürzten, etwa abgebrochenen oder abgeschnittenen Kontaktlaschen eine Kontaktierung eintritt. Nach Abschluss des Schrittes G wird (H) durch eine Spannungsmessschaltung festgestellt, ob zwischen den Stempeln 21a und 21b, d. h. zwischen den Kontaktlaschen, eine Potentialdifferenz auftritt, die mindestens 20 mV beträgt. Positivenfalls geht der Rücknahmeprozess mit I weiter, negativenfalls mit J, wo durch eine Generatorschaltung über die Stempel 21a und 21b ein Spannungsstoss an die Kontaktlaschen gelegt wird, der ca. 1 sec dauert und im Normalfall eine Maximalspannung von 14 V erreicht. Zum Schutz gegen Kurzschluss wird er allerdings so geregelt, dass eine Stromstärke von 30 mA nicht überschritten wird. Anschliessend wird (K) noch einmal überprüft, ob zwischen den Kontaktlaschen nun eine Potentialdifferenz von mindestens 20 mV auftritt oder nicht. Bei positivem Resultat wird die Position I erreicht, andernfalls L.

In der Position I wird
(a) eine Anzeige "Rücknahme" an der Vorderfront des Geräts eingeschaltet und ein Pfand in Form eines bedruckten Zettels oder eines Jetons ausgegeben,
(b) die Weiche 13 in der vorderen (Rücknahme-) Position belassen,
(c) die Halterung 15 durch den Elektromotor 16 in ihre Ruheposition gehoben und damit die Stempel 20a,b, 21a,b und 22a,b,c aus dem Aufnahmefach 1 zurückgezogen,
(d) die Bodenplatte 7 durch den Elektromotor 3 zurückgezogen, sodass die Batterie auf die Weiche 13 und weiter in den Sammelbehälter fällt und anschliessend wieder in die Ausgangsposition gebracht,
(e) der Riegel 10 durch den Elektromagneten 11 zurückgezogen und der Schieber 8 entriegelt.

In der Position L wird
(a') eine Anzeige "keine Rücknahme" an der Vorderfront des Geräts eingeschaltet,
(b') Die Weiche 13 in die hintere (Rückgabe-) Position geklappt.

Dann werden die Schritte (c) bis (e) wie in I ausgeführt, wobei natürlich in Schritt (d) die Batterie in den Rückgabeschacht 14 und nicht in den Sammelbehälter fällt. Zwischen den Schritten (d) und (e) wird die Weiche 13 in die vordere (Rücknahme-) Position zurückgeklappt.

Statt der Ausgabe eines Pfandes kann in I auch vorgesehen werden, ein mit dem Rücknahmegerät verbundenes Geschicklichkeits- oder Glücksspielgerät in Gang zu setzen, das einen Gewinn oder ein Pfand auswerfen kann.

Von I oder L kehrt das Gerät nach C - Feststellung, ob der Schieber 8 geschlossen ist - zurück, welche Position wiederum bis zum Auftreten eines negativen Resultats periodisch durchlaufen wird.

Die Steuerung des geschilderten Ablaufs geschieht durch einen entsprechend programmierten Mikroprozessor. Die Spannungsmessschaltung und die Generatorschaltung sind aus diskreten Elementen aufgebaut, sind jedoch Varianten von elektronischen Schaltungen, die dem Fachmann bekannt sind. Zur Stromversorgung dient ein Netzanschluss.

Bei anderen Batterietypen ist der Ablauf völlig analog. 9V - Batterien werden in die Nische 1c eingelegt und von den Stempeln 20a,b kontaktiert. Zylindrische Batterien wie Monozellen und Knopfzellen werden in das linke Teilfach 1a gelegt und gleiten wegen dessen Keilform entsprechend ihrem Durchmesser weiter oder weniger weit in das Innere desselben. Die Kontaktierung erfolgt jeweils durch mindestens einen der Stempel 22a,b,c und der gegenüberliegenden in die Bodenplatte 7 eingelassenen Kontakte 23a,b,c. Eine gefederte Befestigung der Stempel 22a,b,c an der Halterung 15 ist nicht vorgesehen, da ja die Kontaktierung immer nur durch einen derselben zu erfolgen braucht und daher kein Höhenausgleich erforderlich ist.

Das Gerät ist zur Zurücknahme sämtlicher derzeit im Haushalt verwendeter Batterietypen geeignet. Zur Erleichterung des richtigen Einlegens der Batterien können die Umrisse gängiger Typen auf der Rückwand des Aufnahmefachs 1 oder auf dem Schieber 8 in der richtigen Einlegeposition entsprechend den gestrichelten Eintragungen in Fig. 4a eingezeichnet sein.

Die Unterscheidung zwischen Batterien und anderen Objekten beruht darauf, dass Batterien fast immer eine Restspannung aufweisen, die normalerweise über 20 mV liegt. Das wird in H überprüft. Ist eine Batterie so vollständig entladen, dass sie keine derartige Restspannung mehr zeigt, so kann sie fast immer durch einen Spannungsstoss wieder soweit aufgeladen werden (J), dass die Spannung zwischen ihren Polen anschliessend mindestens diesen Wert erreicht (in K überprüft). Wie bereits erwähnt, spielt es dabei keine Rolle, ob die Polarität des Spannungsstosses mit derjenigen der Batterie übereinstimmt. Die Wahrscheinlichkeit dafür, dass eine Batterie, die wie beschrieben geprüft wird, nicht als solche erkannt wird und zur Position L gelangt, ist sehr gering. Versuche haben ergeben, dass sie bei höchstens 1% liegt. Für solche nichterkannte Batterien kann neben den Rücknahmegerät ein Rücknahmebehälter vorgesehen werden. Entscheidend dürfte sein, dass die Rücknahmerate mit mindestens 99% so hoch ist, dass beim Publikum keine Frustrationen entstehen dürften.

## Patentansprüche

1. Verfahren zur Rücknahme gebrauchter Artikel, bei welchem, nachdem ein Gegenstand in ein Aufnahmefach (1) eingelegt wurde, derselbe darauf überprüft wird, ob er zur Rücknahme geeignet ist, wonach er bei positivem Resultat der Prüfung in einen Sammelbehälter weitergeleitet und andernfalls zurückgegeben wird, **dadurch gekennzeichnet, dass** der eingelegte Gegenstand zur Prüfung, ob es sich um eine Batterie handelt, an mindestens zwei Kontaktstellen von elektrisch leitenden Kontaktstücken berührt und als Kriterium des positiven Prüfungsresultats festgestellt wird, ob zwischen den Kontaktstellen eine einen vorgegebenen Grenzwert erreichende Spannung auftritt.

2. Verfahren nach Anspruch 1, **dadurch gekennzeichnet, dass** der Grenzwert bei 20 mV liegt.

3. Verfahren nach Anspruch 1 oder 2, **dadurch gekennzeichnet, dass** vor der Ueberprüfung allfälliger elektrischer Spannungen zwischen zwei Kontaktstellen des eingelegten Gegenstandes mittels der Kontaktstücke ein elektrischer Spannungsstoss zwischen besagten Kontaktstellen wirksam gemacht wird.

4. Verfahren nach Anspruch 3, **dadurch gekennzeichnet, dass** der Spannungsstoss erst wirksam gemacht wird, nachdem bei einer ersten Messung keine den vorgegebenen Grenzwert erreichende Spannung zwischen den Kontaktstellen des eingelegten Gegenstandes festgestellt wurde.

5. Verfahren nach Anspruch 3 oder 4, **dadurch gekennzeichnet, dass** der elektrische Spannungsstoss ca. 1 sec dauert und so geregelt ist, dass eine Spannung von 14 V und eine Stromstärke von 30 mA nicht überschritten werden.

6. Verfahren nach einem der Ansprüche 1 bis 5, **dadurch gekennzeichnet, dass** das Aufnahmefach (1) mit einer Tür versehen ist und dass dieselbe, nachdem sie geöffnet und wieder geschlossen wurde, verriegelt wird, bis die Prüfung eines allfällig eingelegten Gegenstandes abgeschlossen ist und anschliessend - mindestens bei positivem Prüfungsresultat erst, nachdem der Gegenstand aus dem Aufnahmefach (1) entfernt wurde - wieder entriegelt wird.

7. Vorrichtung zur Durchführung des Verfahrens nach Ansprüch 1 mit einem Aufnahmefach (1) zum Einlegen eines Gegenstandes, wobei im Aufnahmefach (1) Kontaktstücke angeordnet sind, die mit einer Prüfschaltung, welche geeignet ist, allfällige elektrische Spannungen zwischen zwei Kontaktstücken festzustellen, verbunden sind und die Vorrichtung ferner einen Sammelbehälter und einen Rückgabeschacht (14) aufweist sowie eine zwischen denselben und dem Aufnahmefach (1) angeordnete von der Prüfschaltung gesteuerte Weiche (13).

8. Vorrichtung nach Anspruch 7, **dadurch gekennzeichnet, dass** sie eine Generatorschaltung zur Erzeugung von Spannungsstössen zwischen Kontaktstückpaaren aufweist.

9. Vorrichtung nach Anspruch 8, **dadurch gekennzeichnet, dass** mindestens ein Teil der Kontaktstücke als im Boden oder in der Wand des Aufnahmefachs (1) eingelassene Kontakte (23a, 23b, 23c) ausgebildet sind.

10. Vorrichtung nach Anspruch 8 oder 9, **dadurch gekennzeichnet, dass** mindestens ein Teil der Kontaktstücke als im Aufnahmefach (1) vorschieb- und zurückziehbare Stempel (20a, 20b, 21a, 21b, 22a, 22b, 22c) ausgebildet sind.

11. Vorrichtung nach Anspruch 10, **dadurch gekennzeichnet, dass** die Stempel (20a, 20b, 21a, 21b, 22a, 22b, 22c) auf einer Halterung (15) montiert sind, welche durch mindestens eine Feder (2a, 2b) in Vorschubrichtung vorgespannt und durch eine Antriebseinrichtung in Rückzugsrichtung bewegbar ist.

12. Vorrichtung nach Anspruch 11, **dadurch gekennzeichnet, dass** die Stempel (20a, 20b, 21a, 21b) mindestens zum Teil in Bewegungsrichtung gefedert auf der Halterung (15) montiert sind.

13. Vorrichtung nach einem der Ansprüche 7 bis 12, **dadurch gekennzeichnet, dass** das Aufnahmefach (1) eine Türe aufweist und ein Sensor (9), welcher feststellt, ob sie geschlossen ist oder nicht, vorhanden ist sowie eine Verriegelung.

14. Vorrichtung nach Anspruch 13, **dadurch gekennzeichnet, dass** sie einen Mikroschalter (12) aufweist, welcher den Zustand der Verriegelung feststellt.

## Claims

1. Method for returning used articles, in which, after an object has been placed in a receiving compartment (1), said object is checked as to whether it is suitable for return, after which, with a positive result, it is forwarded to a collection container and otherwise rejected, **characterised in that** the object placed in for testing whether it is a battery is contacted by electrically conducting contact makers on at least two contact points and it is established as a criterion of a positive test result whether a voltage which reaches a given threshold value occurs between the contact points.

2. Method according to Claim 1, **characterised in that** the threshold value is about 20 mV.

3. Method according to Claim 1 or 2, **characterised in that**, prior to checking any electric voltages, by means of the contact makers, between two contact points of the object placed in, an electric voltage surge is effected between said contact points.

4. Method according to Claim 3, **characterised in that** the voltage surge is only effected after no voltage which reaches the given threshold value was established in a first measurement between the contact points of the object placed in.

5. Method according to Claim 3 or 4, **characterised in that** the electric voltage surge lasts about 1 sec and is regulated in such a way that a voltage of 14 V and a current strength of 30 mA are not exceeded.

6. Method according to one of Claims 1 to 5, **characterised in that** the receiving compartment (1) is provided with a door, and in that the latter, after it has been opened and closed again, is locked until the testing of any object placed in has been completed and is subsequently - at least with a positive test result only after the object has been removed from the receiving compartment (1) - unlocked again.

7. Apparatus for carrying out the method according to one of Claims 1 to 6, having a receiving compartment (1) for insertion of an object, **characterised in that** there are arranged in the receiving compartment (1) contact makers which are connected to a test circuit which is suitable for establishing any electric voltages between two contact makers and the apparatus furthermore has a collection container and a rejection shaft (14) and a switch (13) which is arranged between said rejection shaft and the receiving compartment (1) and is controlled by the test circuit.

8. Apparatus according to Claim 7, **characterised in that** it has a generator circuit for generating voltage surges between pairs of contact makers.

9. Apparatus according to Claim 8, **characterised in that** at least some of the contact makers are designed as contacts (23a, 23b, 23c) which are recessed in the bottom or in the wall of the receiving compartment (1).

10. Apparatus according to Claim 8 or 9, **characterised in that** at least some of the contact makers are designed as rams (20a, 20b, 21a, 21b, 22a, 22b, 22c) which can be advanced and withdrawn in the receiving compartment (1).

11. Apparatus according to Claim 10, **characterised in that** the rams (20a, 20b, 21a, 21b, 22a, 22b, 22c) are mounted on a fastening (15) which is prestressed in the advance direction by at least one spring (2a, 2b) and can be moved in the withdrawal direction by a drive device.

12. Apparatus according to Claim 11, **characterised in that** the rams (20a, 20b, 21a, 21b), at least in part, are spring-mounted on the fastening (15) in the direction of movement.

13. Apparatus according to one of Claims 7 to 12, **characterised in that** the receiving compartment (1) has a door and there is a sensor (9), which establishes whether or not the door is closed, and a lock.

14. Apparatus according to Claim 13, **characterised in that** it has a microswitch (12) which establishes the state of the lock.

## Revendications

1. Procédé de récupération d'articles usagés, suivant lequel, après gu'un objet ait été déposé dans un réceptacle (1), il est examiné pour vérifier s'il convient à la récupération, à la suite de quoi, dans le cas où le résultat de la vérification est positif, l'objet est acheminé dans un conteneur collecteur et, dans le cas contraire, il est restitué, caractérisé en ce que l'objet introduit est mis en contact, en au moins deux points de contact, avec des pièces de contact conductrices de l'électricité pour vérifier s'il s'agit d'une pile, et il est constaté, en tant que critère d'un résultat de vérification positif, la survenance d'une tension, atteignant une valeur limite prédéterminée, entre les points de contact.

2. Procédé selon la revendication 1, caractérisé en ce que la valeur limite est de 20 mV.

3. Procédé selon la revendication 1 ou 2, caractérisé en ce que, avant la vérification d'éventuelles tensions électriques entre deux points de contact de l'objet introduit, un choc de tension électrique est produit entre lesdits points de contact au moyen des pièces de contact.

4. Procédé selon la revendication 3, caractérisé en ce que le choc de tension n'est produit qu'après que, lors d'une première mesure, aucune tension atteignant la valeur limite prédéterminée n'ait été constatée entre les points de contact de l'objet introduit.

5. Procédé selon la revendication 3 ou 4, caractérisé en ce que le choc de tension électrique dure à peu près 1 seconde et est réglé de manière à ne pas dépasser une tension de 14 V et un intensité de courant de 30 mA.

6. Procédé selon l'une des revendications 1 à 5, caractérisé en ce que le réceptacle (1) est pourvu d'une porte et en ce que cette dernière, après avoir été ouverte et de nouveau fermée, est verrouillée, jusqu'à ce que la vérification d'un objet y ayant été éventuellement introduit soit achevé et, ensuite - au moins dans le cas où le résultat de la vérification est positif, après que l'objet ait été enlevé du réceptacle (1) - est de nouveau déverrouillée.

7. Dispositif pour la mise en oeuvre du procédé selon la revendication 1, comprenant un réceptacle (1), pour y introduire un objet, des pièces de contact étant disposées dans le réceptacle (1), lesquelles sont reliées à un circuit de contrôle agencé pour constater la survenance d'éventuelles tensions électriques entre deux pièces de contact, et le dispositif présentant en outre un conteneur collecteur et un conduit de retour (14), ainsi qu'un aiguillage (13), disposé entre ceux-ci et le réceptacle (1) et commandé par le circuit de vérification.

8. Dispositif selon la revendication 7, caractérisé en ce qu'il comprend un circuit générateur, destiné à produire des chocs de tension entre des couples de pièces de contact.

9. Dispositif selon la revendication 8, caractérisé en ce qu'au moins une partie des pièces de contact sont réalisées sou forme de contacts (23a, 23b, 23c) noyés dans le fond ou dans la paroi du réceptacle (1).

10. Dispositif selon la revendication 8 ou 9, caractérisé en ce qu'au moins une partie des pièces de contact sont réalisées sous forme de poussoirs (20a, 20b, 21a, 21b, 22a, 22b, 22c) susceptibles d'être déployés et rétractés dans le réceptacle (1).

11. Dispositif selon la revendication 10, caractérisé en ce que les poussoirs (20a, 20b, 21a, 21b, 22a, 22b, 22c) sont montés sur un support (15), précontraint dans la direction de déploiement à l'aide d'au moins un ressort (2a, 2b) et déplaçables dans la direction de la rétraction au moyen d'un dispositif d'entraînement.

12. Dispositif selon la revendication 11, caractérisé en ce que les poussoirs (20a, 20b, 21a, 21b), sont, au moins en partie, montés sur le support (15) de façon élastique dans la direction de déplacement.

13. Dispositif selon l'une des revendications 7 à 12, caractérisé en ce que le réceptacle (1) comporte une porte et un capteur (9), qui constate si elle est fermée ou non, ainsi que s'il y a verrouillage.

14. Dispositif selon la revendication 13, caractérisé en ce qu'il comporte un micro-interrupteur (12) constatant l'état de verrouillage.
